Europäisches Patentamt

European Patent Office

Office européen des brevets

(11) Publication number: **0 260 201 B1**

## EUROPEAN PATENT SPECIFICATION

(45) Date of publication of patent specification: **03.06.92**  (51) Int. Cl.⁵: **H01L 21/31**, H01L 21/314

(21) Application number: **87402028.2**

(22) Date of filing: **11.09.87**

(54) Plasma etching using a bilayer mask.

(30) Priority: **11.09.86 US 906346**

(43) Date of publication of application:
**16.03.88 Bulletin 88/11**

(45) Publication of the grant of the patent:
**03.06.92 Bulletin 92/23**

(84) Designated Contracting States:
**DE FR GB IT NL**

(56) References cited:
**EP-A- 0 001 030**
**EP-A- 0 002 185**
**FR-A- 2 399 486**
**US-A- 3 971 684**
**US-A- 4 484 978**

**IEEE TRANS. ON NUCLEAR SCIENCE, vol.
NS-26, no. 6, December 1979, pages
4868-4873, New York, US; E.A. BURKE et al.:
"Energy deposition by soft X-rays - an ap-
plication to lithography for VLSI"**

**EXTENDED ABSTRACTS, vol. 83-1, May 1983,
pages 675-676, Pennington, New Jersey, US;
M. MORIJIRA et al.: "Preferential etching of
multilayered chromium and copper based
on an electrochemical technology"**

(73) Proprietor: **FAIRCHILD SEMICONDUCTOR
CORPORATION**
**10400 Ridgeview Court P.O. Box 1500**
**Cupertino, California 95014(US)**

(72) Inventor: **Cleeves, James M.**
**551 Summit Drive**
**Redwood City California 94062(US)**
Inventor: **Heard, James G.**
**10560 Glenview Avenue**
**Cupertino California 95014(US)**
Inventor: **Tan, Zoilo C. H.**
**10630 Madrid Road**
**Cupertino California 95014(US)**

(74) Representative: **Sparing Röhl Henseler Paten-
tanwälte European Patent Attorneys**
**Rethelstrasse 123**
**W-4000 Düsseldorf 1(DE)**

## Description

The present invention relates generally to the field of semiconductor fabrication, and more particularly to a method for plasma etching using a bilayer mask in order to define very small geometries on a semiconductor substrate.

As the drive to increase device density continues, it becomes increasingly necessary to be able to define very small geometries on the surface of a semiconductor substrate. To form such small geometries, it is highly desirable to use very thin resist layers which provide for precise replication of the projected masking pattern. Image resolution and definition are lost as the thickness of the photoresist layer increases.

The ability to utilize very thin photoresist layers, however, is limited by the need to provide a resist layer which is sufficiently thick to withstand the etching of the underlying layer which is being patterned through the resist mask. In particular, plasma etching often requires a relatively thick resist layer since it is a relatively lengthy process and many etchant gases directly attack the resist material. For that reason, the resist layers used as masks in plasma etching processes are often too thick to allow for submicron geometries, as is frequently desired.

For the above reasons, it would be desirable to provide methods which would combine the advantages of a thin resist layer, i.e., high image resolution, definition, and control, with the ability to withstand the relatively harsh conditions associated with plasma etching.

According to the present invention, this problem is addressed by the features cited respectively in claims 1 or 7.

It is to be noted that EP-A-2 185 discloses a method for plasma etching a primary layer consisting of an Al-Cu-Si alloy formed on a semiconductor substrate. The known method comprises the steps of forming a chromium metal image layer over the primary layer, the chromium layer having a thickness sufficient to withstand subsequent plasma etching of the primary layer, forming a resist layer over the chromium layer, photolithographically patterning the resist to form a first mask, etching the chromium layer through the first mask to form a second mask, and plasma etching the primary layer through the second mask under conditions which etch the primary layer in preference to the chromium layer.

The present invention will be explained hereunder with reference to the accompanying drawings.

## BRIEF DESCRIPTION OF THE DRAWINGS

Fig. 1 illustrates a conventional semiconductor substrate having a primary layer, a metal image layer, and a resist layer formed successively over its surface.

Fig. 2 illustrates the structure of Fig. 1, wherein the resist layer has been patterned.

Fig. 3 illustrates the structure of Fig. 2, wherein the metal image layer has been patterned using the resist layer as a mask.

Fig. 4 illustrates the structure of Fig. 3, wherein the primary layer has been patterned using the metal image layer as a mask.

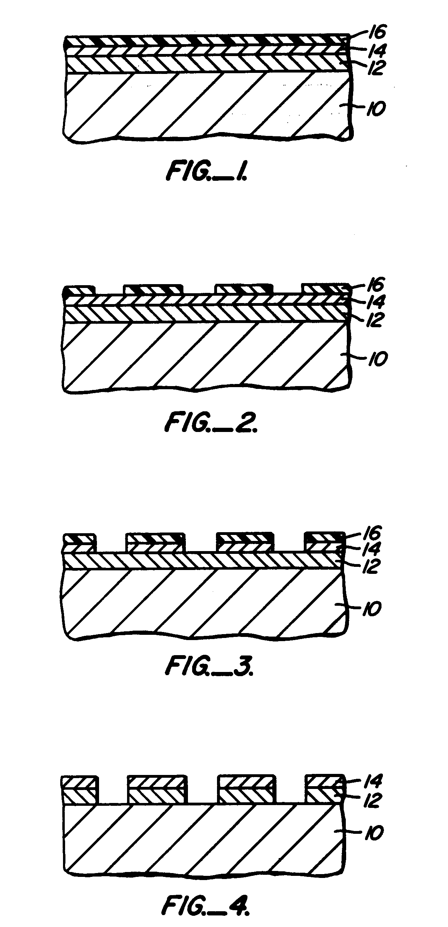

Referring generally to Figs. 1-4, specific methods will be described for fabricating semiconductor devices according to the method of the present invention.

Semiconductor devices are fabricated on silicon wafer substrates 10 (a portion of one being illustrated in Figs. 1-4). Usually, the wafer will include a variety of features (not illustrated) formed on its upper surface, including transistors, resistors, capacitors, and the like.

According to the present invention, a primary layer 12, which is an aluminum layer will be formed over the substrate 10 using conventional techniques. The primary layer 12 is patterned using a bilayer mask including a metal imaging layer 14 and a resist layer 16, which is specifically intended to provide for high resolution plasma etching of the primary layer.

The primary layer 12 is an aluminum layer formed by conventional techniques, such as sputter deposition or evaporation. Usually, the aluminum layer 12 will be a metallization layer intended for interconnecting the various features formed on the substrate 10.

While the primary layer 12 is aluminum, the metal imaging layer will be chromium, typically applied by sputter deposition or evaporation. The chromium layer 14 must be sufficiently thick to withstand the subsequent plasma etching of the primary layer 12, as described hereinafter. Thicknesses in the range from 0,01 to 0,2 $\mu$m (100 to 2000 Å), more usually in the range from 0,05 to 0,1 $\mu$m (500 to 1000 Å), are suitable.

The nature of the resist layer 16 is not dependent on the nature of the primary layer 12, but must be able to protect the underlying metal imaging layer 14. Suitable resist materials include photoresists, electron beam resists, and x-ray resists. The thickness of the resist layer will depend both on the desired image resolution and on the need to cover irregular surface topographies. With planarized surfaces, resists as thin as 0.2 $\mu$m may be employed, providing for etched geometries of 0.5 $\mu$m and below. In the case of irregular surface topographies, resist layers having a thickness in the range from about 1 to 2 $\mu$m may find use. The resists are applied by conventional spin-on techniques to the desired thickness, and cured.

Referring now to Fig. 2, the resist layer 16 is patterned by conventional techniques, such as light exposure for photoresists, electron beam exposure for electron beam resist, and x-ray exposure for x-ray resists. After exposure, the resists are developed to provide a desired mask for subsequent etching of the underlying metal imaging layer 14.

Once the resist layer 16 has been patterned, it is used as a mask for etching the metal image layer 14, as illustrated in Fig. 3. The chromium metal imaging layer 14 may be etched using conventional wet etchants, such as ceric ammonium sulfate-based etchants, at room temperature.

After patterning, the metal imaging layer 14 is used as a mask for plasma etching the primary layer 12. In the case of aluminum primary layer 12, a chlorine plasma is employed as described above.

After etching, the substrate will appear as illustrated in Fig. 4, with the resist layer 16 having been removed during the plasma etch of the primary layer. If desired, the metal imaging layer 14 may be removed by conventional techniques. The chromium imaging layer can be removed by wet etching with ceric ammonium sulfate-based etchants or with an oxygen

Use of the present invention provides for high resolution plasma etching of aluminum metallization layers.

By employing a bilayer mask including both a metal imaging layer and a resist layer, very thin resist layers providing for high resolution and definition can be utilized. By then using the photoresist to pattern the metal imaging layer, a mask combining both the high resolution of a thin photoresist and the durability of a metal is achieved.

## Claims

1. A method for plasma etching a primary aluminium layer formed on a semiconductor substrate, said method comprising:

    forming a chrominium metal image layer over the primary aluminium layer, said chromium layer having a thickness in the range from 0,01 - 0,2 $\mu$m;

    forming a thin resist layer having a thickness in the range from 0.2 to 2 $\mu$m over the thin metal layer;

    photolithographically patterning the resist to form a first mask;

    etching the chromium metal layer through the first mask to form a second mask; and

    plasma etching the primary layer through the second mask under conditions which etch the aluminium layer in preference to the chromium layer.

2. A method as in cliam 1, wherein the resist is an electron beam resist.

3. A method as in claim 1, wherein the resist is an x-ray resist.

4. A method as in claim 1, wherein the chromium layer is wet etched with a ceric ammonium sulfate-based etchant at room temperature.

5. A method as in claim 1, wherein the aluminium layer is etched with a chlorinated plasma.

6. A method for etching an aluminium layer on a semiconductor substrate, said method comprising:

    forming a layer of chromium having a thickness in the range from 0,05 - 0,1 $\mu$m over the aluminium layer:

    forming a thin resist layer having a thickness in the range from 0.2 to 2 $\mu$m over the chromium layer;

    photolithographically patterning the resist layer to form a first mask;

    etching the chromium layer with a ceric ammonium sulfate-based etchant through the first mask to form a second mask; and

    plasma etching the aluminium layer through the second mask with a chlorine plasma etchant.

7. A method as in claim 6, wherein the resist is an electron beam resist.

8. A method as in claim 6, wherein the resist is an x-ray resist.

9. A method as in claim 6, wherein the chrominium layer is formed by sputtering or evaporation.

## Revendications

1. Procédé pour le gravage au plasma d'une couche d'aluminium primaire formée sur un substrat semiconducteur, ledit procédé consistant à :

    former une couche image de métal en chrome sur la couche d'aluminium primaire, ladite couche de chrome ayant une épaisseur s'étendant dans la gamme de 0,01 à 0,2 $\mu$m;

    former une fine couche de résine ayant une épaisseur s'étendant dans la gamme de 0,2 à 2 $\mu$m sur la fine couche de métal;

    configurée de façon photolithographique la résine pour former un premier masque;

    graver la couche de métal en chrome à travers le premier masque pour former un second masque; et

graver au plasma la couche primaire à travers le second masque dans les conditions qui gravent la couche d'aluminium de façon privilégiée par rapport à la couche de chrome.

**2.** Procédé selon la revendication 1 dans lequel la résine est une résine pour faisceau d'électrons.

**3.** Procédé selon la revendication I dans lequel la résine est une résine pour rayons-x.

**4.** Procédé selon la revendication 1 dans lequel la couche de chrome est gravée de façon humide à l'aide d'un agent de gravage à base de sulfate d'ammonium cérique à température ambiante.

**5.** Procédé selon la revendication 1 dans lequel la couche d'aluminium est gravée à l'aide d'un plasma chloré.

**6.** Procédé pour graver une couche d'aluminium sur un substrat semiconducteur, ledit procédé consistant à :

former une couche de chrome ayant une épaisseur s'étendant dans la gamme de 0,05 à 0,1 $\mu$m sur la couche d'aluminium;

former une fine couche de résine ayant une épaisseur s'étendant dans la gamme de 0,2 à 2 $\mu$m sur la couche de chrome;

configurée de façon photolithographique la couche de résine pour former un premier masque;

graver la couche de chrome à l'aide d'un agent de gravage à base de sulfate d'ammonium cérique à travers le premier masque pour former un second masque; et

graver au plasma la couche d'aluminium à travers le second masque à l'aide d'un gravage au plasma au chlore.

**7.** Procédé selon la revendication 6 dans lequel la résine est une résine pour faisceau d'électrons.

**8.** Procédé selon la revendication 6 dans lequel la résine est une résine pour rayons-x

**9.** Procédé selon la revendication 6 dans lequel la couche de chrome est formée par métallisation sous vide ou par évaporation.

**Patentansprüche**

**1.** Ein Verfahren für das Plasma-Ätzen einer auf einem Halbleitersubstrat ausgebildeten primären Aluminiumschicht, welches Verfahren umfaßt:

Bilden einer Chrom-Metall-Bildschicht über der primären Aluminiumschicht, welche Chromschicht eine Dicke im Bereich von 0,01-0,2 $\mu$m aufweist,

Bilden einer dünnen Resistschicht mit einer Dicke in der Größenordnung von 0,2 bis 2 um über der dünnen Metallschicht;

photolithographisches Mustern des Resists zur Ausbildung einer ersten Maske;

Ätzen der Chrom-Metallschicht durch die erste Maske zur Bildung einer zweiten Maske; und

Plasma-Ätzen der primären Schicht durch die zweite Maske unter Bedingungen, bei denen die Aluminiumschicht vorzugsweise gegenüber der Chromschicht geätzt wird.

**2.** Ein Verfahren nach Anspruch 1, bei dem das Resist ein Elektronenstrahlresist ist.

**3.** Ein Verfahren nach Anspruch 1, bei dem das Resist ein Röntgenstrahlresist ist.

**4.** Ein Verfahren nach Anspruch 1, bei dem die Chromschicht naßgeätzt wird mit einem cerinsauren Ammonium-Sulfat-basierten Ätzmittel bei Zimmertemperatur geätzt wird.

**5.** Ein Verfahren nach Anspruch 1, bei dem die Aluminiumschicht mit einem chlorierten Plasma geätzt wird.

**6.** Ein Verfahren für das Ätzen einer Aluminiumschicht auf ein Halbleitersubstrat, welches Verfahren umfaßt:

Bilden einer Schicht von Chrom mit einer Dicke im Bereich von 0,05 - 0,1 um über der Aluminiumschicht;

Bilden einer dünnen Resistschicht mit einer Dicke im Bereich von 0,2 - 2 um über der Chromschicht;

photolithographisches Mustern der Resistschicht zur Bildung einer ersten Maske;

Ätzen der Chromschicht mit einem cerinsauren Ammoniumsulfat-basierten Ätzmittel durch die erste Maske zur Bildung einer zweiten Maske;

und Plasma-Ätzen der Aluminiumschicht durch die zweite Maske mit einem chlorierten Plasma-Ätzmittel.

**7.** Ein Verfahren nach Anspruch 6, bei dem das Resist ein Elektronenstrahlresist ist.

**8.** Ein Verfahren nach Anspruch 6, bei dem das Resist ein Röntgenstrahlenresist ist.

**9.** Ein Verfahren nach Anspruch 6, bei dem die Chromschicht durch Sputtern oder Aufdampfen gebildet wird.

FIG.\_1.

FIG.\_2.

FIG.\_3.

FIG.\_4.